(19) Europäisches Patentamt
European Patent Office
Office européen des brevets

(11) **EP 4 513 752 B1**

(12) **EUROPEAN PATENT SPECIFICATION**

(45) Date of publication and mention
of the grant of the patent:
**08.07.2026 Bulletin 2026/28**

(21) Application number: **23815016.3**

(22) Date of filing: **23.05.2023**

(51) International Patent Classification (IPC):
*H04B 1/44* *(2006.01)*    *H04B 1/04* *(2006.01)*
*H04B 1/18* *(2006.01)*    *H03F 1/34* *(2006.01)*
*H03F 1/56* *(2006.01)*    *H03F 3/195* *(2006.01)*
*H03F 3/24* *(2006.01)*

(52) Cooperative Patent Classification (CPC):
**H03F 1/565; H03F 1/347; H03F 3/195; H03F 3/245;**
**H04B 1/0458; H04B 1/18; H04B 1/44;**
H03F 2200/294; H03F 2200/451

(86) International application number:
**PCT/CN2023/095754**

(87) International publication number:
**WO 2023/231832 (07.12.2023 Gazette 2023/49)**

(54) **RADIO FREQUENCY SWITCH CIRCUIT, WIRELESS TRANSCEIVING SYSTEM AND ELECTRONIC DEVICE**

HOCHFREQUENZSCHALTUNG, DRAHTLOSES SENDE-/EMPFANGSSYSTEM UND ELEKTRONISCHE VORRICHTUNG

CIRCUIT DE COMMUTATION RADIOFRÉQUENCE, SYSTÈME D'ÉMISSION-RÉCEPTION SANS FIL ET DISPOSITIF ÉLECTRONIQUE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **30.05.2022 CN 202210603028**

(43) Date of publication of application:
**26.02.2025 Bulletin 2025/09**

(73) Proprietor: **Huawei Technologies Co., Ltd.**
**Shenzhen, Guangdong 518129 (CN)**

(72) Inventors:
• **QIU, Qilin**
**Shenzhen, Guangdong 518129 (CN)**

• **ZHANG, Mingming**
**Shenzhen, Guangdong 518129 (CN)**

(74) Representative: **MERH-IP Matias Erny Reichl Hoffmann**
**Patentanwälte PartG mbB**
**Paul-Heyse-Straße 29**
**80336 München (DE)**

(56) References cited:
EP-B1- 2 419 997          WO-A1-2011/143504
CN-A- 103 546 101         CN-A- 108 063 600
CN-A- 110 932 747         CN-A- 113 517 869
US-A1- 2017 194 918       US-A1- 2017 194 918
US-A1- 2019 074 862       US-A1- 2020 389 133

## Description

### TECHNICAL FIELD

This application relates to the field of wireless signal transceiver technologies, and in particular, to a radio frequency switch circuit, a wireless transceiver system, and an electronic device.

### BACKGROUND

Currently, in a wireless communication device, a same antenna is used to transmit and receive a signal. Therefore, to switch between a transmit link and a receive link, a radio frequency switch circuit is required to connect the transmit link, the receive link, and an antenna together, and to switch between signal transmission and signal reception.

In a simplified circuit architecture, the transmit link includes an amplifier PA output matching network, and the receive link includes a low noise amplifier LNA input matching network. In this way, a switching device and a matching circuit are combined. The radio frequency switch circuit generally includes a switching device to implement switching between signal transmission and signal reception. The switching device is integrated in the LNA input matching network. During signal transmission, the switching device is turned on; during signal reception, the switching device is turned off. The PA output matching network may include a transformer. The LNA input matching network may include an inductor.

However, an improperly selected inductor in the LNA input matching network may reduce an output power and work efficiency of the PA output matching network.

Document EP 2 419 997 B1 generally discloses a low noise amplifier (LNA) with combined input matching, balun, and/or transmit/receive (T /K) switch. In one exemplary design, an apparatus includes a coupled inductor and an LNA. The coupled inductor receives a single-ended input signal, performs single-ended to differential conversion, and provides a differential input signal. The LNA receives and amplifies the differential input signal and provides a differential output signal. The coupled inductor includes magnetically coupled first and second coils. The first coil provides input impedance matching when the LNA is enabled. A resonator circuit formed with the first coil provides high input impedance when the LNA is disabled. A tuning capacitor coupled to the second coil provides amplitude imbalance tuning for the differential input signal. A transmit switch is coupled between the first coil and a transmitter.

Document US 2017/194918 A1 generally discloses an impedance transformation circuit for use in an amplifier, such as a low noise amplifier. The impedance transformation circuit includes a matching circuit including a first inductor. The impedance transformation circuit also includes a second inductor. The first and second inductors are magnetically coupled to each other to provide negative feedback to linearize the amplifier.

Document WO 2011/143504 A1 generally discloses an integrated circuit for transmit and receive matching. The integrated circuit includes a transmit amplifier. The transmit amplifier includes a first transistor, a second transistor and a first inductor. The first inductor couples the first transistor to the second transistor. The integrated circuit also includes a low noise amplifier. The low noise amplifier includes a third transistor, a fourth transistor, the first inductor, a second inductor, a third inductor and a transformer. The second inductor couples the first inductor to the third transistor. The third inductor couples the third transistor to ground.

### SUMMARY

To resolve the foregoing technical problem, this application provides a radio frequency switch circuit, a wireless transceiver system, and an electronic device, to increase an output power of a PA output matching network and improve work efficiency. In particular, this application provides a radio frequency switch circuit, a wireless transceiver system, and an electronic device, having the features of respective independent claims. The dependent claims relate to preferred embodiments.

According to a first aspect, this application provides a radio frequency switch circuit, including: a power amplifier PA output matching network and a low noise amplifier LNA input matching network. An output end of the PA output matching network is configured to connect to an antenna, and an input end of the PA output matching network is configured to connect to a power amplifier PA. The LNA input matching network includes: a first coupling device, a second coupling device, and a switching device. The first coupling device and the second coupling device are mutually coupled. A first end of the first coupling device is configured to connect to the antenna, a second end of the first coupling device is connected to a first end of the switching device, the second end of the first coupling device is connected to a first end of a low noise amplifier LNA, a second end of the switching device is connected to a first end of the second coupling device, a second end of the second coupling device is grounded, and a third end of the second coupling device is connected to a second end of the low noise amplifier LNA. During signal transmission, the switching device is turned on, so that the first coupling device and the second coupling device are connected in series, and overall impedance after the serial connection increases. Therefore, an equivalent coupling inductance of a transformer may be increased, and thus an equivalent coupling coefficient of the transformer is increased, so that an output power and efficiency of the PA can be improved. In other words, during signal transmission, strength of a signal transferred from the PA to the antenna is greater, thereby improving work efficiency. In addition, during signal transmission, a radio frequency signal output by the PA needs to pass through the PA output matching network to reach the antenna, but a part of the signal is transmitted to ground, that is, lost, by passing through the series-connected first coupling device and the second coupling device. In this application, to reduce a loss, to the ground, of the radio frequency signal output by the PA, during signal transmission, the first coupling device and the second coupling device are connected in series, so that a signal loss path has high impedance, resulting in fewer signals lost from the series-connected first coupling device and the second coupling device to the ground. During signal reception, the switching device is turned off.

This application does not limit specific implementations of the first coupling device and the second coupling device, which may be implemented by using coupled transmission lines or implemented by using inductors.

In a first implementation, the first coupling device includes a first inductor, the second coupling device includes a second inductor, and the first end of the first coupling device and the first end of the second coupling device are dotted terminals. In a second implementation, the first coupling device and the second coupling device may alternatively be coupled transmission lines.

In a possible implementation, the LNA input matching network further includes a direct-current blocking capacitor, and the second end of the first coupling device is connected to the first end of the LNA through the direct-current blocking capacitor. The direct-current blocking capacitor is configured to isolate a direct current, that is, only allow an alternating current signal to pass through.

A possible implementation of the LNA is described below. The LNA includes a switching transistor, the second end of the first coupling device is connected to a first end of the switching transistor, the third end of the second coupling device is connected to a third end of the switching transistor, and a second end of the switching transistor is used as a signal output end of the LNA.

When the second coupling device is the second inductor, because the second inductor is a three-terminal device, a position of a tap can be adjusted to change a value of an inductance between a source of the switching transistor in the LNA and the ground, so that a source negative feedback inductance can also be adjusted to an optimal value, to meet a requirement of the low noise amplifier LNA input matching network.

In a possible implementation, to save an area occupied by the two inductors on a circuit board, in a spatial layout, the first inductor and the second inductor at least partially overlap in space, so that the two inductors may occupy an area of only one inductor.

In a possible implementation, the PA output matching network includes a transformer, where the transformer includes a first winding and a second winding; and two ends of the first winding are configured to connect to an output end of the PA, a first end of the second winding is configured to connect to the antenna, and a second end of the second winding is grounded. In addition to transmitting energy, the transformer may further implement a function of isolating an interference signal. The transformer may alternatively be replaced by another device, for example, a transmission-line balun or a coupled transmission line.

In a possible implementation, the PA output matching network further includes a first matching capacitor and a second matching capacitor, where the first matching capacitor is connected in parallel to two ends of the third inductor, and the second matching capacitor is connected in parallel to two ends of the fourth inductor.

In a possible implementation, a controller is further included. The controller is configured to: during signal transmission, send a drive signal to a control end of the switching device to control the switching device to be turned on, so that the first coupling device and the second coupling device are connected in series; and during signal reception, send a drive signal to the control end of the switching device to control the switching device to be turned off. This application does not specifically limit a type of the controller, which may be a wireless transceiver chip or the like to perform control.

Based on the radio frequency switch circuit provided above, this application further provides a wireless transceiver system including the radio frequency switch circuit described above, and further including a power amplifier PA and a low noise amplifier LNA. The PA is connected to an antenna through a PA output matching network in the radio frequency switch circuit. The PA is configured to send a wireless signal to the antenna through the PA output matching network, where the antenna is configured to transmit the wireless signal. The LNA is connected to the antenna through an LNA input matching network in the radio frequency switch circuit. The LNA is configured to receive a wireless signal from the antenna through the LNA input matching network.

Because the radio frequency switch circuit included in the wireless transceiver system provided in this embodiment of this application can improve the output power and efficiency of the power amplifier, an overall transmit power of the wireless transceiver system is increased, and signal transmission efficiency is also improved.

This application further provides an electronic device, including a wireless transceiver system, and an antenna. The wireless transceiver system is connected to the antenna. The antenna is configured to transmit a wireless signal of the wireless transceiver system, and is configured to send a received wireless signal to the wireless transceiver system. A specific form of the electronic device is not specifically limited in this application. For example, the electronic device may be a mobile phone, a phone watch, a tablet, or another terminal device that can receive and send a wireless signal.

In the electronic device provided in this application, to reduce a loss, to ground, of a radio frequency signal output by a PA, during signal transmission, a first coupling device and a second coupling device are connected in series, so that a signal loss path has high impedance, resulting in fewer signals lost from the series-connected first coupling device and the second coupling device to the ground. Therefore, transmission efficiency of a wireless signal is improved, so that a communication bandwidth of the electronic device can be increased, and communication efficiency can be improved.

This application has at least the following advantages:

A radio frequency switch circuit provided in this application includes a power amplifier PA output matching network and a low noise amplifier LNA input matching network. An output end of the PA output matching network is configured to connect to an antenna, and an input end of the PA output matching network is configured to connect to a power amplifier PA. The LNA input matching network includes: a first coupling device, a second coupling device, and a switching device that are mutually coupled. During signal transmission, the switching device is turned on. In this case, the first coupling device and the second coupling device are connected in series, and therefore, overall impedance after the serial connection increases. Therefore, an equivalent coupling inductance of a transformer may be increased, and thus an equivalent coupling coefficient of the transformer is increased, so that an output power and efficiency of the power amplifier PA can be improved. In other words, during signal transmission, strength of a signal transferred from the power amplifier PA to the antenna is greater, thereby improving work efficiency. In addition, during signal transmission, a radio frequency signal output by the power amplifier PA needs to pass through the power amplifier output matching network to reach the antenna, but a part of the signal is transmitted to ground by passing through the series-connected first coupling device and the second coupling device, that is, energy is leaked to the ground, causing an energy loss. In this application, to reduce a loss, to the ground, of the radio frequency signal output by the power amplifier PA, during signal transmission, the first coupling device and the second coupling device are connected in series, so that a signal loss path has high impedance, resulting in fewer signals lost from the series-connected first coupling device and the second coupling device to the ground.

## BRIEF DESCRIPTION OF DRAWINGS

FIG. 1 is a diagram of a radio frequency switch circuit;
FIG. 2 is a topology diagram of a radio frequency switch circuit;
FIG. 3 is a diagram of an equivalent circuit corresponding to FIG. 2;
FIG. 4 is a diagram of a radio frequency switch circuit according to an embodiment of this application;
FIG. 5 is a diagram of still another radio frequency switch circuit according to an embodiment of this application;
FIG. 6 is a diagram of a specific circuit corresponding to FIG. 5;
FIG. 7 is a diagram of an equivalent circuit of signal transmission corresponding to FIG. 5;
FIG. 8 is a diagram of an equivalent circuit of signal reception corresponding to FIG. 5;
FIG. 9 is a diagram of yet another radio frequency switch circuit according to an embodiment of this application;
FIG. 10 is a diagram of an equivalent model of coupled transmission lines according to an embodiment of this application;
FIG. 11 is a diagram of an equivalent circuit corresponding to FIG. 10;
FIG. 12 is a diagram of an equivalent circuit of signal transmission corresponding to FIG. 9;
FIG. 13 is a diagram of a wireless transceiver system according to an embodiment of this application; and
FIG. 14 is a diagram of an electronic device according to an embodiment of this application.

## DESCRIPTION OF EMBODIMENTS

To make a person skilled in the art better understand a technical solution provided in embodiments of this application, the following first describes an application scenario of a radio frequency switch circuit.

In embodiments of this application, an example in which the radio frequency switch circuit is applied to an electronic device to transmit and receive a wireless signal is used. For example, the electronic device may be a mobile terminal device such as a mobile phone, or may be another electronic device having a wireless signal receiving and sending function. For example, during wireless communication, a mobile phone receives a wireless signal by using an antenna. After receiving the wireless signal, the antenna preprocesses the wireless signal by using a low noise amplifier LNA input matching network, and transfers the processed wireless signal to an LNA. The LNA filters out noise and amplifies the wireless signal for a next-stage circuit. The next-stage circuit receives a radio frequency signal. The next-stage circuit may be a frequency mixer or a phase shifter. This is not specifically limited in embodiments of this application. Similarly, when the mobile phone transmits a wireless signal, the frequency mixer or the phase shifter sends a radio frequency signal to a PA. After amplifying the radio frequency signal, the PA processes the amplified radio frequency signal by using a PA output matching network, and then sends the processed radio frequency signal to an antenna. The antenna transmits the radio frequency signal. The radio frequency switch circuit provided in embodiments of this application is a processing circuit for receiving and sending a radio frequency signal in an electronic device.

The following describes a radio frequency switch circuit with reference to the accompanying drawings.

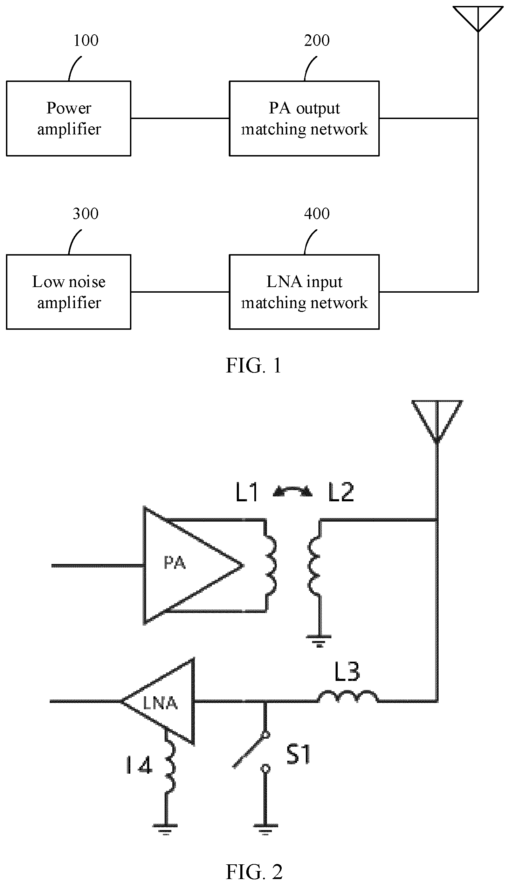

FIG. 1 is a diagram of a radio frequency switch circuit.

The radio frequency switch circuit generally includes: a power amplifier PA output matching network 200 and a low noise amplifier LNA input matching network 400, where an input end of the PA output matching network 200 is connected to a power amplifier 100, and an output end of the PA output matching network 200 is connected to an antenna. An output end of the LNA input matching network 400 is connected to a low noise amplifier 300, and an input end of the LNA input matching network 400 is connected to the antenna, that is, the PA output matching network 200 is located on a transmit link, and the LNA input matching network 400 is located on a receive link.

FIG. 2 is a topology diagram of a radio frequency switch circuit.

FIG. 2 describes a specific implementation of a PA output matching network and an LNA input matching network. The PA output matching network includes a transformer, that is, includes inductors L1 and L2. The LNA input matching network includes an inductor L3 and a switching transistor S1, and further includes a source negative feedback circuit L4. For example, an LNA includes a transistor inside, and a source of the transistor is grounded through an inductor L4, to form the source negative feedback circuit. An input end of the LNA is connected to an antenna through the inductor L3.

When a working state of the radio frequency switch circuit is transmitting, S1 is turned on; when the working state of the radio frequency switch circuit is receiving, S1 is turned off.

The following analyzes disadvantages of the corresponding circuit in FIG. 2 with reference to an equivalent circuit diagram.

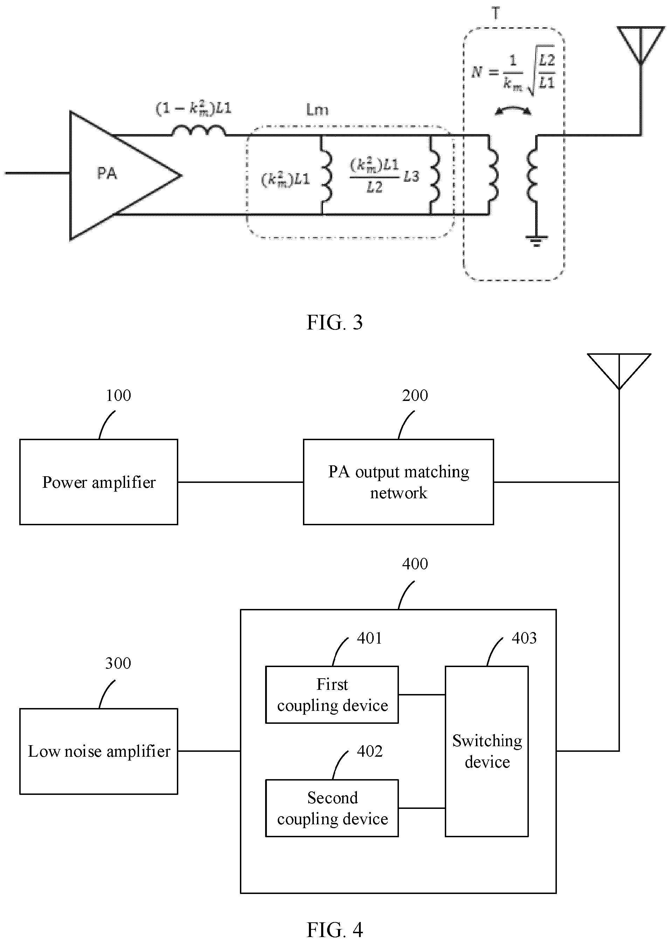

FIG. 3 is a diagram of an equivalent circuit corresponding to FIG. 2.

In FIG. 3, a transformer formed by L1 and L2 is equivalent to an ideal transformer. When S1 is turned on, $k_m$ is a coupling coefficient of the transformer. A voltage conversion ratio of the ideal transformer is $N = \frac{1}{k_m}\sqrt{\frac{L2}{L1}}$. After L3 is equivalently converted to a left side of the ideal transformer, an equivalent inductance value of the L3 is $\frac{(k_m^2)L1}{L2}L3$, and L3 is connected in parallel with an inductor $(k_m^2)L1$ to form an equivalent coupled inductor. In an equivalent model of a transformer, a larger equivalent coupling inductance indicates a higher equivalent coupling coefficient of the transformer. In this case, an expression of an equivalent coupled inductor $L_m$ is:

$$L_m = \frac{(k_m^2)L1}{1+\frac{L2}{L3}}$$

It can be learned that a smaller value of L3 indicates a smaller value of $L_m$.

As L3 is an LNA input matching circuit, L3 has an optimal value. If the value of L3 is changed from the optimal value to another value, a noise and a voltage standing wave ratio of a receive link deteriorate. However, if L3 is not changed, the equivalent coupling coefficient of the transformer decreases. The decrease of the equivalent coupling coefficient increases an insertion loss of the PA output matching network, and reduces an output power and efficiency of a PA.

Therefore, to improve the output power and the efficiency of the PA, an embodiment of this application provides a radio frequency switch circuit, to reduce the output power and the efficiency of the PA. The following provides detailed descriptions with reference to the accompanying drawing.

FIG. 4 is a diagram of a radio frequency switch circuit according to an embodiment of this application.

The radio frequency switch circuit provided in this embodiment includes: a power amplifier PA output matching network 200 and a low noise amplifier LNA input matching network 400.

An output end of the PA output matching network 200 is configured to connect to an antenna, and an input end of the PA output matching network 200 is configured to connect to a power amplifier 100.

The LNA input matching network 400 includes: a first coupling device 401, a second coupling device 402, and a switching device 403, where the first coupling device 401 and the second coupling device 402 are coupled to each other. It should be understood that the first coupling device 401 and the second coupling device 402 are mainly magnetically coupled.

A first end of the first coupling device 401 is configured to connect to the antenna, a second end of the first coupling device 401 is connected to a first end of the switching device 403, the second end of the first coupling device 401 is connected to a first end of a low noise amplifier 300, a second end of the switching device 403 is connected to a first end of the second coupling device 402, a second end of the second coupling device 402 is grounded, and a third end of the second coupling device 402 is connected to a second end of the low noise amplifier 300.

During signal transmission, the switching device 403 is turned on, so that the first coupling device 401 and the second coupling device 402 are connected in series; and during signal reception, the switching device 403 is turned off.

Specific implementations of the first coupling device 401 and the second coupling device 403 are not specifically limited in this embodiment of this application. For example, the first coupling device 401 includes a first inductor, the second coupling device 402 includes a second inductor, the first end of the first coupling device 401 and the first end of the second coupling device are dotted terminals, and the first inductor and the second inductor are magnetically coupled to each other.

In another possible implementation, the first coupling device 401 and the second coupling device 402 may be implemented by using a coupled transmission line. A function of the coupled transmission line is similar to that of an inductor.

According to the radio frequency switch circuit provided in this embodiment of this application, during signal transmission, the switching device is turned on. In this case, the first coupling device and the second coupling device are connected in series, and therefore, overall impedance after the serial connection increases. Therefore, an equivalent coupling inductance of a transformer may be increased, and thus an equivalent coupling coefficient of the transformer is increased, so that an output power and efficiency of the PA can be improved. In other words, during signal transmission, strength of a signal transferred from the PA to the antenna is greater, thereby improving work efficiency. In addition, during signal transmission, a radio frequency signal output by the PA needs to pass through the PA output matching network to reach the antenna, but a part of the signal is transmitted to ground, that is, lost, by passing through the series-connected first coupling device and the second coupling device. In this application, to reduce a loss, to the ground, of the radio frequency signal output by the PA, during signal transmission, the first coupling device and the second coupling device are connected in series, so that a signal loss path has high impedance, resulting in fewer signals lost from the series-connected first coupling device and the second coupling device to the ground.

The following first describes a case in which both the first coupling device and the second coupling device are inductors with reference to the accompanying drawing.

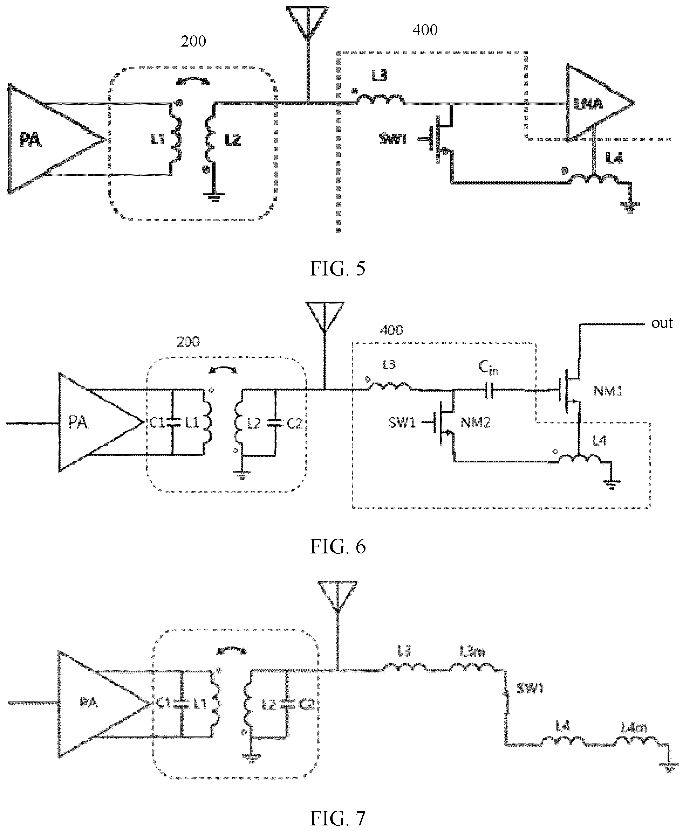

FIG. 5 is a diagram of still another radio frequency switch circuit according to an embodiment of this application.

In the radio frequency switch circuit shown in FIG. 5, a coupling device provided in this embodiment of this application is implemented by an inductor. To be specific, a first coupling device is a first inductor L3, a second coupling device is a second inductor L4, where a first end of the first inductor L3 and a first end of the second inductor L4 are dotted terminals, and the first inductor L3 and the second inductor L4 is magnetically coupled.

A switching device is SW 1. It can be learned from FIG. 5 that, a first end of the switching device SW 1 is connected to the first inductor L3, a second end of the switching device SW 1 is connected to a first end of the second inductor L4, a second end of the second inductor L4 is grounded, a third end of the second inductor L4 is connected to a second end of a low noise amplifier LNA, and a second end of the first inductor L3 is connected to a first end of the low noise amplifier LNA.

When the switching device SW 1 is turned on, the first inductor L3 and the second inductor L4 are connected in series. The second inductor L4 is a three-terminal device, that is, the second inductor L4 includes a center tap, that is, the center tap of the second inductor L4 is connected to a source of the low noise amplifier LNA, to form a source negative feedback circuit.

For a transmit link, an example in which a PA output matching network 200 includes a transformer is used for description. An output end of a power amplifier PA is connected to a first winding L1 of the transformer, a first end of a second winding L2 of the transformer is connected to an antenna, and a second end of the second winding L2 is grounded.

In addition, the PA output matching network 200 shown in FIG. 5 includes a transformer, where the transformer may also be replaced by another component, for example, a transmission-line balun or a coupled transmission line.

During signal transmission, that is, when the power amplifier PA transmits a signal to the antenna, the switching device SW 1 is turned on, so that the first inductor L3 and the second inductor L4 are connected in series; and during signal reception, the switching device SW 1 is turned off.

To make a person skilled in the art better understand the technical solution provided in embodiments of this application, the following describes an operating principle in detail with reference to the accompanying drawing. An example in which the low noise amplifier LNA includes a switching transistor is used for description.

FIG. 6 is a diagram of a specific circuit corresponding to FIG. 5.

In FIG. 6, an example in which the low noise amplifier includes a switching transistor NM 1 is used, and the PA output matching network 200 and the LNA input matching network 400 are improved.

The LNA input matching network 400 further includes a direct-current blocking capacitor Cin.

The second end of the first inductor L3 is connected to a first end of the switching transistor NM 1 through the direct-current blocking capacitor Cin, a third end of the switching transistor NM 1 is connected to the third end of the second inductor L4, and a second end of the switching transistor NM 1 serves as a signal output end (out) of the LNA.

The PA output matching network further includes: a first matching capacitor C1 and a second matching capacitor C2.

The first matching capacitor C1 is connected in parallel to two ends of the first winding L1, and the second matching capacitor C2 is connected in parallel to two ends of the second winding L2, that is, the PA output matching network is an LC matching network.

In FIG. 6, an example in which the switching device SW 1 is an NMOS transistor NM 2, and the switching transistor NM 1 is also an NMOS transistor is used for description.

To save an area occupied by the two inductors on a circuit board, in a spatial layout, the first inductor L3 and the second inductor L4 at least partially overlap in space, so that the two inductors may occupy an area of only one inductor.

The following describes a detailed operating principle with reference to an equivalent circuit diagram during signal transmission.

FIG. 7 is a diagram of an equivalent circuit of signal transmission corresponding to FIG. 5.

FIG. 7 shows a circuit during signal transmission, that is, a circuit connection relationship when the switching device SW 1 is turned on during signal transmission. It can be learned from FIG. 7 that, L3m and L4m are respectively coupled inductances generated by coupling of the first inductor L3 and the second inductor L4, and L3m=L4m. During signal transmission, SW 1 is turned on, and the first inductor L3 and the second inductor L4 and the L3m and the L4m are connected in series and then grounded. During signal reception, SW 1 is turned off, and a current flowing through the low noise amplifier is grounded through L4. The foregoing four series-connected inductors may be equivalent to an independent inductor $L_{rx\text{-}tt}$, and the following equation is met:

$$L_{rx-tt} = L3 + L3m + L4 + L4m$$

If an on resistance of SW 1 is $R_{sw}$, an equivalent quality factor $Q_{eq}$ of the LNA input matching network may be calculated as follows:

$$Q_{eq} = \frac{\omega L_{rx-tt}}{R_{sw}} = \frac{\omega(L3 + L3m + L4 + L4m)}{R_{sw}}$$

The following describes an equivalent circuit during signal reception with reference to the accompanying drawing.

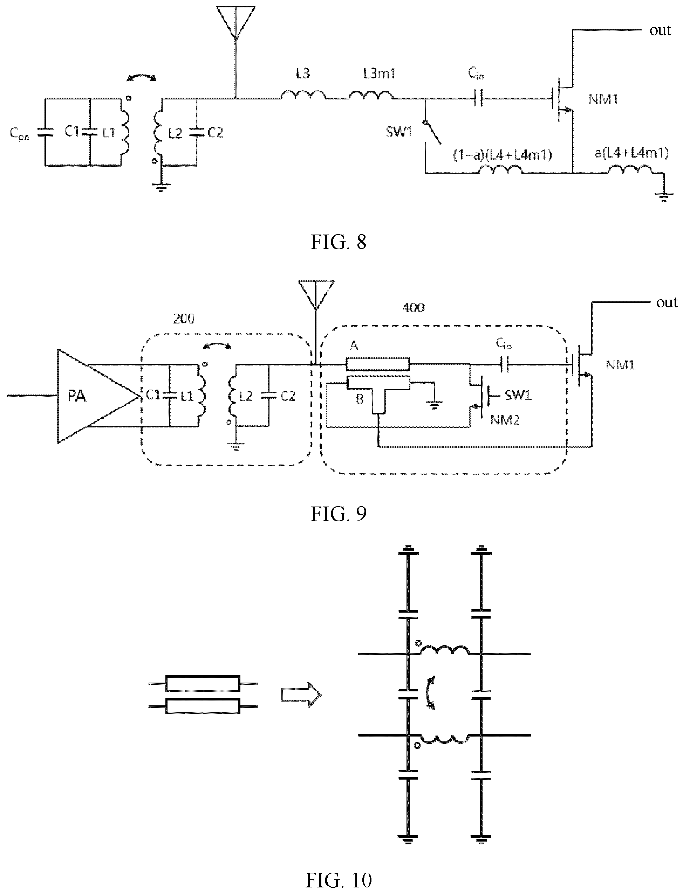

FIG. 8 is a diagram of an equivalent circuit of signal reception corresponding to FIG. 5.

As shown in FIG. 8, during signal reception, that is, a radio frequency signal reaches the LNA from the antenna by passing through the LNA input matching network, the switching device SW 1 is turned off, where Cpa is a parasitic capacitor when the power amplifier does not work, and a represents a tap position at which a source of the switching transistor NM 1 is connected to the second inductor L4.

It should be understood that, when the switching device SW 1 is turned on, the first inductor L3 and the second inductor L4 are connected in series. However, when the switching device SW 1 is turned off, the first inductor L3 and the second inductor L4 are not connected in series. Therefore, coupled inductances generated by coupling of the first inductor L3 and the second inductor L4 when the SW 1 is turned on are different from coupled inductances generated when the switching device SW 1 is turned off. For differentiation, in FIG. 8, L3m1 and L4m1 respectively represent the coupled inductances generated by coupling of the first inductor L3 and the second inductor L4.

Because the second inductor L4 is a three-terminal device, a position of the tap can be adjusted to change a value of an inductance a(L4+L4m1) between the source of NM 1 and the ground, so that the source negative feedback inductance a(L4+L4m1) can also be adjusted to an optimal value, to meet a requirement of the low noise amplifier LNA input matching network.

A manner of adjusting a position of a is not specifically limited in this embodiment of this application. For example, a plurality of switches may be disposed, and a specific position of a is changed by controlling different states of the switches. In addition, a semiconductor process may be used for implementation. For example, the inductor is implemented by using a metal wire on a circuit board, and the position of a may be changed by interrupting the metal wire by using a laser.

Because the second inductor in the radio frequency switch circuit provided in this embodiment of this application includes the tap, the position of a may be selected based on a specific application scenario, so that an inductance value is adjusted to an optimal value. In this way, the inductance is adjusted more flexibly, facilitating a design of a circuit layout.

It can be learned from FIG. 8 that, during signal reception, because the switching device SW 1 is turned off, L3 and L4 are not in a series connection relationship, and a current is transferred to the ground by passing through the source of the NM 1 and the part a(L4+L4m1) of the second inductor L4.

It should be understood that, in the radio frequency switch circuit provided in this embodiment of this application, the source of the low noise amplifier LNA is grounded through the inductor, so that a real part of an input impedance at a gate end of a transistor in the low noise amplifier LNA can be increased. When the real part of the input impedance at the gate end of the transistor in the low noise amplifier LNA is relatively small, a complex input matching network needs to be designed. Further, the relatively small input impedance reduces a bandwidth, and the complex input matching network increases an insertion loss and a noise. In this embodiment of this application, the source of the low noise amplifier LNA is grounded through the inductor, to form a source negative feedback, so that the real part of the input impedance at the gate end of the transistor in the low noise amplifier LNA can be increased, thereby increasing the bandwidth, and reducing the insertion loss and the noise.

The following analyzes, with reference to formulas, how the radio frequency switch circuit provided in this embodiment of this application can increase an output power of the PA.

To maintain the inductance of the LNA input matching network of a receive link at an optimal value, L3+L3m needs to be an optimal value of an LNA input matching inductance shown in FIG. 2. In the radio frequency switch circuits shown in FIG. 2 and FIG. 5, calculation formulas of equivalent coupling inductances of transformers in the PA output matching networks are respectively:

$$L_{m0} = \frac{(k_m^2)L1}{1 + \frac{L2}{L3+L3m}}$$

$$L_{m1} = \frac{(k_m^2)L1}{1 + \frac{L2}{L_{rx-tt}}} = \frac{(k_m^2)L1}{1 + \frac{L2}{L3+L3m+L4+L4m}}$$

$L_{m0}$ is an equivalent coupling inductance of the transformer shown in FIG. 2, and $L_{m1}$ is an equivalent coupling inductance of the transformer shown in FIG. 5. It can be learned by comparing the foregoing two formulas that, the equivalent coupling inductance of the transformer shown in FIG. 5 is greater than the equivalent coupling inductance of the transformer shown in FIG. 2. Therefore, the radio frequency switch circuit provided in this embodiment of this application improves an equivalent coupling coefficient of the transformer. When the equivalent coupling coefficient of the transformer is larger, more energy is transferred by the transformer from the first winding to the second winding, that is, energy transmission efficiency is higher. Therefore, the radio frequency switch circuit provided in this embodiment of this application can improve the output power and efficiency of the PA, and can further increase a bandwidth of a wireless communication signal of an electronic device, and improve transmission efficiency.

If the on resistance of the SW 1 is $R_{sw}$, for FIG. 5 and FIG. 2, calculation formulas of equivalent quality factors of circuits of the series-connected inductors on the right side of the antenna in FIG. 5 are respectively:

$$Q_{eq0} = \frac{\omega L_{rx-tt}}{R_{sw}} = \frac{\omega(L3 + L3m)}{R_{sw}}$$

$$Q_{eq1} = \frac{\omega L_{rx-tt}}{R_{sw}} = \frac{\omega(L3 + L3m + L4 + L4m)}{R_{sw}}$$

$Q_{eq0}$ is an equivalent quality factor of FIG. 2, and $Q_{eq1}$ is an equivalent quality factor of FIG. 5. The formula indicates that the equivalent quality factor of FIG. 5 is greater than that of FIG. 2. Therefore, the equivalent quality factor of the PA output matching network is improved, so that the output power and efficiency of the PA are improved.

It should be understood that, because both the switching transistor and the switching device in the radio frequency switch circuit provided in this embodiment of this application are controllable switching transistors, a controller is needed to control switching actions of the switching transistor and the switching device. Therefore, the radio frequency switch circuit provided in this embodiment of this application further includes a controller. The controller is configured to: during signal transmission, send a drive signal to a control end of the switching device to control the switching device to be turned on, so that the first coupling device and the second coupling device are connected in series; and during signal reception, send a drive signal to the control end of the switching device to control the switching device to be turned off.

A specific implementation form of the controller is not specifically limited in this embodiment of this application. For example, the controller may be a controller of the radio frequency switch circuit, or may be a controller of an entire wireless transceiver system. For example, the controller may be a microprocessor, a single-chip microcomputer, or the like. Generally, the controller needs to send a driving pulse signal to a gate of the switching transistor or the switching device.

The foregoing embodiments describe a coupling device in the radio frequency switch circuit with an example in which the coupling device is an inductor. The following describes a case in which the coupling device is implemented by a coupling line.

FIG. 9 is a diagram of yet another radio frequency switch circuit according to an embodiment of this application.

A coupling device in the radio frequency switch circuit provided in this embodiment is implemented by a coupled transmission line.

As shown in FIG. 9, the coupled transmission line includes a first coupled transmission line A and a second coupled transmission line B. A first end of the first coupled transmission line Ais connected to an antenna, and a second end of the first coupled transmission line Ais connected to a first end of a low noise amplifier NM 1 through a direct-current blocking capacitor Cin. The second coupled transmission line B, similar to a second inductor, is also a three-terminal device. A first end of the second coupled transmission line B is connected to a second end of a switching device SW 1 (NM 2), a second end of the second coupled transmission line B is grounded, and a third end of the second coupled transmission line B is connected to a source of the switching transistor NM 1 to form a source negative feedback circuit.

The coupled transmission line has the same function as an inductor, only with a different representation form.

FIG. 10 is a diagram of an equivalent model of coupled transmission lines according to an embodiment of this application.

FIG. 10 shows the equivalent model of the coupled transmission lines, in which inductors and capacitors are included. The following describes the equivalent circuit diagram of the equivalent model shown in FIG. 10 with reference to the accompanying drawing.

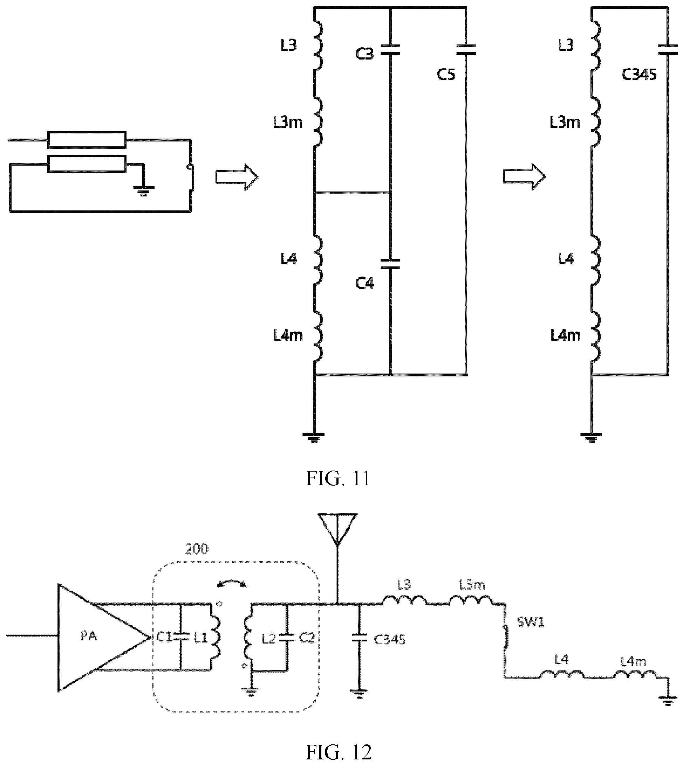

FIG. 11 is a diagram of an equivalent circuit corresponding to FIG. 10.

The coupled transmission lines may be equivalent to two inductors L3 and L4, which are similar to a first inductor and a second inductor described in the foregoing embodiment; L3m and L4m are coupled inductors between the two inductors L3 and L4, and are equivalent to three capacitors, which are C3, C4, and C5, respectively; and a circuit on a left side in FIG. 11 is equivalent to a circuit on a right side in FIG. 11, that is, the three capacitors C3, C4, and C5 are equivalent to one capacitor C345.

An equivalent radio frequency switch circuit of the coupled transmission lines may be obtained according to FIG. 11.

FIG. 12 is a diagram of an equivalent circuit of signal transmission corresponding to FIG. 9.

FIG. 12 is a diagram of an equivalent circuit diagram of signal transmission, that is, a PA transmits a radio frequency signal to an antenna. In this case, the switching device SW 1 is turned on, the first coupled transmission line and the second coupled transmission line are connected in series, that is, equivalent inductors and mutual inductors are all connected in series, and L3, L3m, L4m, and L4 are all connected in series, and are grounded after being connected in series. A first end of the equivalent capacitor C345 is connected to the antenna, and a second end of the equivalent capacitor C345 is grounded.

The following describes a manner of calculating the equivalent capacitance C345:

$$C345 = C5 + \frac{\frac{(L3+L3m)^2 C3 + (L4+L4m)^2 C4}{L3+L3m+L4+L4m} - \omega^2(L3+L3m)(L4+L4m)C3C4}{L3+L3m+L4+L4m - \omega^2(L3+L3m)(L4+L4m)(C3+C4)}$$

ω is an operating frequency of the circuit.

As shown in FIG. 12, C345 and C2 may be combined into one capacitor. In this case, an impact of series-connected inductors in an LNA input matching network on a PA output matching network is the same as that in the embodiment corresponding to FIG. 7.

Similarly, a manner of calculating an equivalent quality factor of the series-connected inductors in the LNA input matching network is also the same as that in the embodiment corresponding to FIG. 7.

Therefore, when the coupling device in the radio frequency switch circuit provided in this embodiment of this application is implemented by using the coupled transmission line, an effect is the same as that can be achieved by the embodiment corresponding to FIG. 7. During signal transmission, impedance of the low noise amplifier LNA input matching network can be increased, so that a radio frequency signal is prevented from leaking to ground through the low noise amplifier LNA input matching network. This increases a transmit power of the power amplifier PA, and improves transmission efficiency of the radio frequency signal of the radio frequency switch circuit.

Based on the radio frequency switch circuit provided in the foregoing embodiments, an embodiment of this application further provides a wireless transceiver system. The following describes in detail with reference to the accompanying drawing.

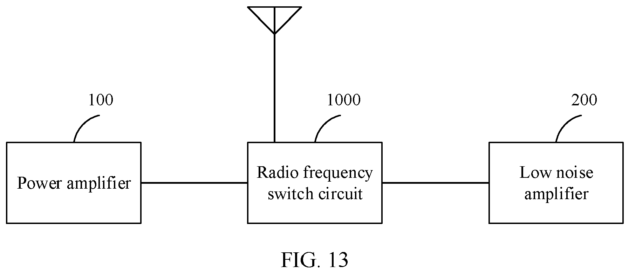

FIG. 13 is a diagram of a wireless transceiver system according to an embodiment of this application.

The wireless transceiver system provided in this embodiment of this application includes a radio frequency switch circuit 1000 described in the foregoing embodiments, and further includes a power amplifier 100 and a low noise amplifier 200.

The power amplifier 100 is connected to an antenna through a power amplifier output matching network in the radio frequency switch circuit.

The power amplifier 100 is configured to send a wireless signal to the antenna through the power amplifier output matching network, where the antenna is configured to transmit the wireless signal.

The low noise amplifier 200 is connected to the antenna through a low noise amplifier input matching network in the radio frequency switch circuit.

The low noise amplifier 200 is configured to receive a wireless signal from the antenna through the low noise amplifier input matching network.

It should be understood that the other end of the power amplifier 100 may be connected to a frequency mixer or a phase shifter, and is configured to generate a radio frequency signal. The power amplifier 100 sends the radio frequency signal to the antenna through the radio frequency switch circuit 1000, and the antenna transmits the radio frequency signal.

Because the radio frequency switch circuit included in the wireless transceiver system provided in this embodiment of this application can improve an output power and efficiency of a power amplifier, an overall transmit power of the wireless transceiver system is increased, and signal transmission efficiency is also improved.

Based on the radio frequency switch circuit and the wireless transceiver system provided in the foregoing embodiments, an embodiment of this application further provides an electronic device. The following describes in detail with reference to the accompanying drawing.

A specific form of the electronic device is not specifically limited in this embodiment of this application. For example, the electronic device may be a mobile phone, a phone watch, a tablet, or another terminal device that can receive and send a wireless signal.

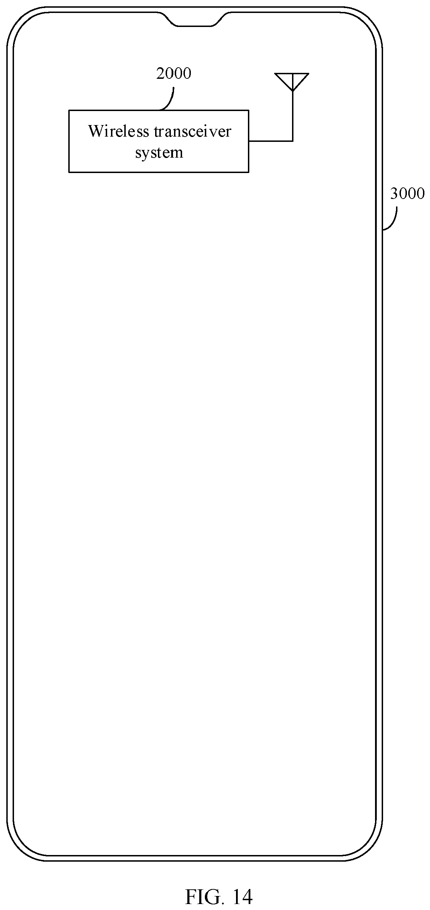

FIG. 14 is a diagram of an electronic device according to an embodiment of this application.

An electronic device 3000 provided in this embodiment of this application includes a wireless transceiver system 2000, and further includes an antenna. The wireless transceiver system 2000 is connected to the antenna.

The antenna is configured to transmit a wireless signal of the wireless transceiver system 2000, and is configured to send a received wireless signal to the wireless transceiver system 2000.

The wireless transceiver system included in the electronic device provided in this embodiment of this application includes a radio frequency switch circuit. Therefore, during signal transmission, a switching device is turned on. In this case, a first coupling device and a second coupling device are connected in series, and therefore, overall impedance after the serial connection increases. Therefore, an equivalent coupling inductance of a transformer may be increased, and thus an equivalent coupling coefficient of the transformer is increased, so that an output power and efficiency of a PA can be improved. In other words, during signal transmission, strength of a signal transferred from the PA to the antenna is greater, thereby improving work efficiency. In addition, during signal transmission, a radio frequency signal output by the PA needs to pass through a PA output matching network to reach the antenna, but a part of the signal is transmitted to ground, that is, lost, by passing through the series-connected first coupling device and the second coupling device.

In this application, to reduce a loss, to the ground, of the radio frequency signal output by the PA, during signal transmission, the first coupling device and the second coupling device are connected in series, so that a signal loss path has high impedance, resulting in fewer signals lost from the series-connected first coupling device and the second coupling device to the ground. Therefore, transmission efficiency of a wireless signal is improved, so that a communication bandwidth of the electronic device can be increased, and communication efficiency can be improved.

It should be understood that in this application, "at least one (item)" refers to one or more and "a plurality of" refers to two or more. The term "and/or" is used for describing an association relationship between associated objects, and represents that three relationships may exist. For example, "A and/or B" may represent the following three cases: Only A exists, only B exists, and both A and B exist, where A and B may be singular or plural. The character "/" generally indicates an "or" relationship between the associated objects. "At least one of the following items (pieces)" or a similar expression thereof means any combination of these items, including any combination of singular items (pieces) or plural items (pieces). For example, at least one of a, b, or c may indicate a, b, c, a and b, a and c, b and c, or a, b, and c, where a, b, and c may be singular or plural.

The foregoing descriptions are merely preferred embodiments of this application, but are not intended to limit this application in any form. Although the preferred embodiments of this application are disclosed above, embodiments are not intended to limit this application. By using the method and the technical content disclosed above, any person of ordinary skill in the art can make a plurality of possible changes and modifications on the technical solutions of this application, or amend the technical solutions thereof to be embodiments with equal effects through equivalent variations.

**Claims**

1. A radio frequency switch circuit, comprising: a power amplifier PA output matching network (200) and a low noise amplifier LNA input matching network (400), wherein

an output end of the PA output matching network (200) is configured to connect to an antenna, and an input end of the PA output matching network (200) is configured to connect to a power amplifier PA (100); and

the LNA input matching network (400) comprises: a first coupling device (401), a second coupling device (402), and a switching device (403), wherein

the first coupling device (401) and the second coupling device (402) are mutually coupled;

a first end of the first coupling device (401) is configured to connect to the antenna, a second end of the first coupling device (401) is connected to a first end of the switching device (403), the second end of the first coupling device (401) is connected to a first end of a low noise amplifier LNA (300), a second end of the switching device (403) is connected to a first end of the second coupling device (402), a second end of the second coupling device (402) is grounded, and a third end of the second coupling device (402) is connected to a second end of the low noise amplifier LNA (300); and

during signal transmission, the switching device (403) is configured to be turned on, so that the first coupling device (401) and the second coupling device (402) are connected in series; and during signal reception, the switching device (403) is configured to be turned off.

2. The radio frequency switch circuit according to claim 1, wherein the first coupling device (401) comprises a first inductor, the second coupling device (402) comprises a second inductor, and the first end of the first coupling device (401) and the first end of the second coupling device (402) are dotted terminals.

3. The radio frequency switch circuit according to claim 1, wherein the first coupling device (401) and the second coupling device (402) are coupled transmission lines.

4. The radio frequency switch circuit according to any one of claims 1 to 3, wherein the LNA input matching network (400) further comprises a direct-current blocking capacitor; and

the second end of the first coupling device (401) is connected to the first end of the LNA (300) through the direct-current blocking capacitor.

5. The radio frequency switch circuit according to any one of claims 1 to 3, wherein the LNA (300) comprises a switching transistor, the second end of the first coupling device (401) is connected to a first end of the switching transistor, the third end of the second coupling device (402) is connected to a third end of the switching transistor, and a second end of the switching transistor is used as a signal output end of the LNA (300).

6. The radio frequency switch circuit according to claim 2, wherein the first inductor and the second inductor at least partially overlap in space.

7. The radio frequency switch circuit according to any one of claims 1 to 6, wherein the PA output matching network (200) comprises a transformer, and the transformer comprises a first winding and a second winding; and

two ends of the first winding are configured to connect to an output end of the PA (100), a first end of the second winding is configured to connect to the antenna, and a second end of the second winding is grounded.

8. The radio frequency switch circuit according to claim 7, wherein the PA output matching network (200) further comprises: a first matching capacitor and a second matching capacitor; and

the first matching capacitor is connected in parallel to two ends of the third inductor, and the second matching capacitor is connected in parallel to two ends of the fourth inductor.

9. The radio frequency switch circuit according to any one of claims 1 to 8, further comprising a controller, wherein the controller is configured to: during signal transmission, send a drive signal to a control end of the switching device (403) to control the switching device (403) to be turned on, so that the first coupling device (401) and the second coupling device (402) are connected in series; and during signal reception, send a drive signal to the control end of the switching device (403) to control the switching device (403) to be turned off.

10. A wireless transceiver system, comprising the radio frequency switch circuit according to any one of claims 1 to 9, and further comprising a power amplifier PA (100) and a low noise amplifier LNA (300), wherein

the PA (100) is connected to an antenna through a PA output matching network (200) in the radio frequency switch circuit;

the PA (100) is configured to send a wireless signal to the antenna through the PA output matching network (200), wherein the antenna is configured to transmit the wireless signal;

the LNA (300) is connected to the antenna through an LNA input matching network (400) in the radio frequency switch circuit; and

the LNA (300) is configured to receive a wireless signal from the antenna through the LNA input matching network (400).

11. An electronic device, comprising the wireless transceiver system according to claim 10, and further comprising an antenna, wherein

the wireless transceiver system is connected to the antenna; and

the antenna is configured to transmit a wireless signal of the wireless transceiver system, and is configured to send a received wireless signal to the wireless transceiver system.

**Patentansprüche**

1. Hochfrequenzumschaltschaltung, umfassend: ein Ausgangsanpassungsnetzwerk eines Leistungsverstärkers, PA-Ausgangsanpassungsnetzwerk (200), und ein Eingangsanpassungsnetzwerk eines rauscharmen Verstärkers, LNA-Eingangsanpassungsnetzwerk (400), wobei

ein Ausgangsende des PA-Ausgangsanpassungsnetzwerks (200) dazu konfiguriert ist, sich mit einer Antenne zu verbinden, und ein Eingangsende des PA-Ausgangsanpassungsnetzwerks (200) dazu konfiguriert ist, sich mit einem Leistungsverstärker, PA, (100) zu verbinden; und

das LNA-Eingangsanpassungsnetzwerk (400) Folgendes umfasst:

eine erste Kopplungsvorrichtung (401), eine zweite Kopplungsvorrichtung (402) und eine Schaltvorrichtung (403), wobei

die erste Kopplungsvorrichtung (401) und die zweite Kopplungsvorrichtung (402) miteinander gekoppelt sind;

ein erstes Ende der ersten Kopplungsvorrichtung (401) dazu konfiguriert ist, sich mit der Antenne zu verbinden, ein zweites Ende der ersten Kopplungsvorrichtung (401) mit einem ersten Ende der Schaltvorrichtung (403) verbunden ist, das zweite Ende der ersten Kopplungsvorrichtung (401) mit einem ersten Ende eines rauscharmen Verstärkers, LNA, (300) verbunden ist, ein zweites Ende der Schaltvorrichtung (403) mit einem ersten Ende der zweiten Kopplungsvorrichtung (402) verbunden ist, ein zweites Ende der zweiten Kopplungsvorrichtung (402) geerdet ist und ein drittes Ende der zweiten Kopplungsvorrichtung (402) mit einem zweiten Ende des rauscharmen Verstärkers, LNA, (300) verbunden ist; und

während einer Signalübertragung, die Schaltvorrichtung (403) dazu konfiguriert ist, eingeschaltet zu werden, sodass die erste Kopplungsvorrichtung (401) und die zweite Kopplungsvorrichtung (402) in Reihe geschaltet werden; und, während eines Signalempfangs, die Schaltvorrichtung (403) dazu konfiguriert ist, ausgeschaltet zu werden.

2. Hochfrequenzumschaltschaltung nach Anspruch 1, wobei die erste Kopplungsvorrichtung (401) eine erste Induktivität umfasst, die zweite Kopplungsvorrichtung (402) eine zweite Induktivität umfasst und das erste Ende der ersten Kopplungsvorrichtung (401) und das erste Ende der zweiten Kopplungsvorrichtung (402) Anschlüsse mit Punktkennzeichnung sind.

3. Hochfrequenzumschaltschaltung nach Anspruch 1, wobei die erste Kopplungsvorrichtung (401) und die zweite Kopplungsvorrichtung (402) gekoppelte Übertragungsleitungen sind.

4. Hochfrequenzumschaltschaltung nach einem der Ansprüche 1 bis 3, wobei das LNA-Eingangsanpassungsnetzwerk (400) ferner einen Gleichstrom-Sperrkondensator umfasst; und

das zweite Ende der ersten Kopplungsvorrichtung (401) mit dem ersten Ende des LNA (300) über den Gleichstrom-Sperrkondensator verbunden ist.

5. Hochfrequenzumschaltschaltung nach einem der Ansprüche 1 bis 3, wobei der LNA (300) einen Schalttransistor umfasst, das zweite Ende der ersten Kopplungsvorrichtung (401) mit einem ersten Ende des Schalttransistors verbunden ist, das dritte Ende der zweiten Kopplungsvorrichtung (402) mit einem dritten Ende des Schalttransistors verbunden ist und ein zweites Ende des Schalttransistors als ein Signalausgangsende des LNA (300) verwendet wird.

6. Hochfrequenzumschaltschaltung nach Anspruch 2, wobei sich die erste Induktivität und die zweite Induktivität zumindest teilweise räumlich überlappen.

7. Hochfrequenzumschaltschaltung nach einem der Ansprüche 1 bis 6, wobei das PA-Ausgangsanpassungsnetzwerk (200) einen Transformator umfasst und der Transformator eine erste Wicklung und eine zweite Wicklung umfasst; und zwei Enden der ersten Wicklung dazu konfiguriert sind, sich mit einem Ausgangsende des PA (100) zu verbinden, ein erstes Ende der zweiten Wicklung dazu konfiguriert ist, sich mit der Antenne zu verbinden, und ein zweites Ende der zweiten Wicklung geerdet ist.

8. Hochfrequenzumschaltschaltung nach Anspruch 7, wobei das PA-Ausgangsanpassungsnetzwerk (200) ferner Folgendes umfasst:

einen ersten Anpassungskondensator und einen zweiten Anpassungskondensator; und
der erste Anpassungskondensator parallel zu zwei Enden der dritten Induktivität geschaltet ist und der zweite Anpassungskondensator parallel zu zwei Enden der vierten Induktivität geschaltet ist.

9. Hochfrequenzumschaltschaltung nach einem der Ansprüche 1 bis 8, ferner umfassend eine Steuerung, wobei die Steuerung zu Folgendem konfiguriert ist: während einer Signalübertragung, Senden eines Ansteuersignals an ein Steuerende der Schaltvorrichtung (403), um die Schaltvorrichtung (403) so zu steuern, dass sie eingeschaltet wird, sodass die erste Kopplungsvorrichtung (401) und die zweite Kopplungsvorrichtung (402) in Reihe geschaltet werden; und während eines Signalempfangs, Senden eines Ansteuersignals an das Steuerende der Schaltvorrichtung (403), um die Schaltvorrichtung (403) so zu steuern, dass sie ausgeschaltet wird.

10. Drahtloses Sende-/Empfängersystem, umfassend die Hochfrequenzumschaltschaltung nach einem der Ansprüche 1 bis 9 und ferner umfassend einen Leistungsverstärker PA (100) und einen rauscharmen Verstärker LNA (300), wobei

der PA (100) mit einer Antenne über ein PA-Ausgangsanpassungsnetzwerk (200) in der Hochfrequenzumschaltschaltung verbunden ist;
der PA (100) dazu konfiguriert ist, ein drahtloses Signal an die Antenne über das PA-Ausgangsanpassungsnetzwerk (200) zu senden, wobei die Antenne dazu konfiguriert ist, das drahtlose Signal zu übertragen;
der LNA (300) mit der Antenne über ein LNA-Eingangsanpassungsnetzwerk (400) in der Hochfrequenzumschaltschaltung verbunden ist; und
der LNA (300) dazu konfiguriert ist, ein drahtloses Signal von der Antenne über das LNA-Eingangsanpassungsnetzwerk (400) zu empfangen.

11. Elektronische Vorrichtung, umfassend das drahtlose Sende-/Empfängersystem nach Anspruch 10 und ferner umfassend eine Antenne, wobei

das drahtlose Sende-/Empfängersystem mit der Antenne verbunden ist; und
die Antenne dazu konfiguriert ist, ein drahtloses Signal des drahtlosen Sende-/Empfängersystems zu übertragen und dazu konfiguriert ist, ein empfangenes drahtloses Signal an das drahtlose Sende-/Empfängersystem zu senden.

**Revendications**

1. Circuit de commutation radiofréquence, comprenant : un réseau d'adaptation de sortie d'amplificateur de puissance PA (200) et un réseau d'adaptation d'entrée d'amplificateur à faible bruit LNA (400), dans lequel

une extrémité de sortie du réseau d'adaptation de sortie PA (200) est configurée pour se connecter à une antenne, et une extrémité d'entrée du réseau d'adaptation de sortie PA (200) est configurée pour se connecter à un amplificateur de puissance PA (100) ; et
le réseau d'adaptation d'entrée LNA (400) comprend : un premier dispositif de couplage (401), un second dispositif de couplage (402), et un dispositif de commutation (403), dans lequel
le premier dispositif de couplage (401) et le second dispositif de couplage (402) sont mutuellement couplés ;
une première extrémité du premier dispositif de couplage (401) est configurée pour se connecter à l'antenne, une seconde extrémité du premier dispositif de couplage (401) est connectée à une première extrémité du dispositif de commutation (403), la seconde extrémité du premier dispositif de couplage (401) est connectée à une première extrémité d'un amplificateur à faible bruit LNA (300), une seconde extrémité du dispositif de commutation (403) est connectée à une première extrémité du second dispositif de couplage (402), une deuxième extrémité du second dispositif de couplage (402) est mise à la terre, et une troisième extrémité du second dispositif de couplage (402) est connectée à une seconde extrémité de l'amplificateur à faible bruit LNA (300) ; et lors de la transmission de signal, le dispositif de commutation (403) est configuré pour être activé, de sorte que le premier dispositif de couplage (401) et le second dispositif de couplage (402) sont connectés en série ; et lors de la réception de signal, le dispositif de commutation (403) est configuré pour être désactivé.

2.  Circuit de commutation radiofréquence selon la revendication 1, dans lequel le premier dispositif de couplage (401) comprend un premier inducteur, le second dispositif de couplage (402) comprend un deuxième inducteur, et la première extrémité du premier dispositif de couplage (401) et la première extrémité du second dispositif de couplage (402) sont des bornes en pointillés.

3.  Circuit de commutation radiofréquence selon la revendication 1, dans lequel le premier dispositif de couplage (401) et le second dispositif de couplage (402) sont des lignes de transmission couplées.

4.  Circuit de commutation radiofréquence selon l'une quelconque des revendications 1 à 3, dans lequel le réseau d'adaptation d'entrée LNA (400) comprend également un condensateur de blocage de courant continu ; et la seconde extrémité du premier dispositif de couplage (401) est connectée à la première extrémité du LNA (300) par l'intermédiaire du condensateur de blocage de courant continu.

5.  Circuit de commutation radiofréquence selon l'une quelconque des revendications 1 à 3, dans lequel le LNA (300) comprend un transistor de commutation, la seconde extrémité du premier dispositif de couplage (401) est connectée à une première extrémité du transistor de commutation, la troisième extrémité du second dispositif de couplage (402) est connectée à une troisième extrémité du transistor de commutation, et une deuxième extrémité du transistor de commutation est utilisée comme extrémité de sortie de signal du LNA (300).

6.  Circuit de commutation radiofréquence selon la revendication 2, dans lequel le premier inducteur et le deuxième inducteur se chevauchent au moins partiellement dans l'espace.

7.  Circuit de commutation radiofréquence selon l'une quelconque des revendications 1 à 6, dans lequel le réseau d'adaptation de sortie PA (200) comprend un transformateur, et le transformateur comprend un premier enroulement et un second enroulement ; et deux extrémités du premier enroulement sont configurées pour se connecter à une extrémité de sortie du PA (100), une première extrémité du second enroulement est configurée pour se connecter à l'antenne, et une seconde extrémité du second enroulement est mise à la terre.

8.  Circuit de commutation radiofréquence selon la revendication 7, dans lequel le réseau d'adaptation de sortie PA (200) comprend également : un premier condensateur d'adaptation et un second condensateur d'adaptation ; et le premier condensateur d'adaptation est connecté en parallèle aux deux extrémités du troisième inducteur, et le second condensateur d'adaptation est connecté en parallèle aux deux extrémités du quatrième inducteur.

9.  Circuit de commutation radiofréquence selon l'une quelconque des revendications 1 à 8, comprenant également un dispositif de commande, dans lequel le dispositif de commande est configuré pour : lors de la transmission de signal, envoyer un signal d'attaque à une extrémité de commande du dispositif de commutation (403) pour commander l'activation du dispositif de commutation (403), de sorte que le premier dispositif de couplage (401) et le second dispositif de couplage (402) sont connectés en série ; et lors de la réception de signal, envoyer un signal d'attaque à l'extrémité de commande du dispositif de commutation (403) pour commander la désactivation du dispositif de commutation (403).

10. Système d'émetteur-récepteur sans fil, comprenant le circuit de commutation radiofréquence selon l'une quelconque des revendications 1 à 9, et comprenant également un amplificateur de puissance, PA (100) et un amplificateur à faible bruit LNA (300), dans lequel

le PA (100) est connecté à une antenne par l'intermédiaire d'un réseau d'adaptation de sortie PA (200) dans le circuit de commutation radiofréquence ;
le PA (100) est configuré pour envoyer un signal sans fil à l'antenne par l'intermédiaire du réseau d'adaptation de sortie PA (200), dans lequel l'antenne est configurée pour transmettre le signal sans fil ;

le LNA (300) est connecté à l'antenne par l'intermédiaire d'un réseau d'adaptation d'entrée LNA (400) dans le circuit de commutation radiofréquence ; et

le LNA (300) est configuré pour recevoir un signal sans fil en provenance de l'antenne par l'intermédiaire du réseau d'adaptation d'entrée LNA (400).

11. Dispositif électronique, comprenant le système d'émetteur-récepteur sans fil selon la revendication 10, et comprenant également une antenne, dans lequel

le système d'émetteur-récepteur sans fil est connecté à l'antenne ; et

l'antenne est configurée pour transmettre un signal sans fil du système d'émetteur-récepteur sans fil, et est configurée pour envoyer un signal sans fil reçu au système d'émetteur-récepteur sans fil.

100

Power
amplifier

200

PA output
matching network

300

Low noise
amplifier

400

LNA input
matching network

FIG. 1

L1 ⇌ L2

PA

L3

LNA

I4

S1

FIG. 2

$$(1 - k_m^2)L1 \qquad Lm \qquad N = \frac{1}{k_m}\sqrt{\frac{L2}{L1}}$$

$$(k_m^2)L1 \qquad \frac{(k_m^2)L1}{L2}L3$$

PA

FIG. 3

100

Power amplifier

200

PA output matching network

300

Low noise amplifier

400

401

First coupling device

402

Second coupling device

403

Switching device

FIG. 4

FIG. 5

FIG. 6

FIG. 7

FIG. 8

FIG. 9

FIG. 10

FIG. 11

FIG. 12

FIG. 13

21

FIG. 14

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 2419997 B1
- US 2017194918 A1
- WO 2011143504 A1